## Europäisches Patentamt
## European Patent Office
## Office européen des brevets

(19)

(11) Veröffentl.chungsnummer : **0 017 903**
**B1**

(12) # EUROPÄISCHE PATENTSCHRIFT

(45) Veröffentlichungstag der Patentschrift :
24.11.82

(51) Int. Cl.³ : **G 01 R 19/155**

(21) Anmeldenummer : **80101885.4**

(22) Anmeldetag : **09.04.80**

(54) **Spannungsfernprüfer.**

(30) Priorität : **12.04.79 DEU 7910822
22.06.79 DE 2925247**

(43) Veröffentlichungstag der Anmeldung :
**29.10.80 (Patentblatt 80/22)**

(45) Bekanntmachung des Hinweises auf die Patenterteilung : **24.11.82 Patentblatt 82/47**

(84) Benannte Vertragsstaaten :
**AT BE CH FR GB IT LI NL SE**

(56) Entgegenhaltungen :
**AT B 286 442
AT B 290 668
DD A 80 950
DE A 2 042 445
DE B 2 619 999**

(73) Patentinhaber : **Karl Pfisterer Elektrotechnische Spezialartikel GmbH & Co. KG
Augsburger Strasse 375
D-7000 Stuttgart 60 (DE)**

(72) Erfinder : **Schächterle, Werner
Forststrasse 26
D-7057 Winnenden (DE)**

(74) Vertreter : **Patentanwälte Dr. Wolff, H. Bartels
Dipl.-Chem. Dr. Brandes Dr.-Ing. Held, Dipl.-Phys.
Wolff
Lange Strasse 51
D-7000 Stuttgart 1 (DE)**

## Spannungs-Fernprüfer

Die Erfindung betrifft einen Spannungs-Fernprüfer für Prüfungen in Hochspannungs-Energieversorgungsnetzen, insbesondere für die Prüfung von Hochspannungsfreileitungen, mit einem als Stab ausgebildeten Griff, der ein Gerätegehäuse trägt, in dem sich ein Prüfgerät befindet, das auf der dem Griff abgekehrten Seite eine Antenne und auf der dem Griff zugekehrten Seite eine Anzeigeeinrichtung aufweist sowie während der Prüfung mit Erdpotential verbunden ist.

Mit den bekannten Spannungs-Fernprüfern dieser Art (DE-B-2 619 999) wird aus größerer Entfernung eine Spannungsprüfung durchgeführt. Der Abstand zwischen dem gegebenenfalls Spannung führenden Leiter und dem Prüfgerät sowie seiner Antenne ist bei der Prüfung so groß, daß eine Isolierung des Gerätegehäuses oder des Griffes nicht notwendig ist. Der kurze Griff ist deshalb bei den bekannten Fernprüfern elektrisch leitend, wodurch eine gute Erdung des Gerätes über die den Griff in der Hand haltende Person erreicht wird. Wegen der Fernmeßmöglichkeit und des kurzen Griffes sind diese Fernprüfer leicht zu handhaben. Sie sind jedoch mit dem Nachteil behaftet, daß Störeinflüsse durch andere Leitungssysteme und durch metallische Bauteile, wie beispielsweise Masten oder Masttraversen, nicht vollständig ausgeschlossen werden können.

Eine sehr weitgehende Unterdrückung von Störeinflüssen läßt sich mit solchen Spannungsprüfern erreichen, die am einen Ende einer Isolierstange eine Prüfelektrode haben, welche mittels der Stange an den zu prüfenden Leiter herangeführt wird. Bei Prüfarbeiten in Hochspannungsnetzen müssen aber aus Sicherheitsgründen die Isolierstangen dieser Spannungsprüfer eine so große Länge haben, daß die Handhabung unter ungünstigen äußeren Bedingungen, beispielsweise dann, wenn die die Prüfung ausführende Person auf einer Traverse stehen muß, schwierig oder gar gefährlich sein kann.

Störeinflüssen durch andere Leitungssysteme und metallische Bauteile ist auch ein anderer, bekannter Fernprüfer ausgesetzt (DE-A-2 042 445), der auf dem Schutzhelm des Benutzers angeordnet ist und bei dem die Verbindung mit dem Erdpotential nicht ausschließlich galvanisch erfolgt, sondern eine kapazitive Ankopplung an den Körper des Schutzhelmträgers vorgesehen ist. Auf die Störempfindlichkeit hat nämlich diese Art der Verbindung mit dem Körper des Benutzers keinen Einfluß.

Die sehr weitgehende Unterdrückung von Störeinflüssen bei denjenigen Spannungsprüfern, die mit einer an den zu prüfenden Leiter anzulegenden Prüfelektrode versehen sind, ist unabhängig davon, ob eine Verbindung mit dem Erdpotential über die Haltestange und den diese festhaltenden Benutzer erfolgt oder, wie ebenfalls bekannt (DD-A-80 950) über ein isoliertes, flexibles Kabel.

Der Erfindung liegt die Aufgabe zugrunde, zur Prüfung der Spannung von Freileitungen, die mittels Isolatoren an Traversen aufgehängt sind, ein Gerät zu schaffen, das wegen seiner relativ kleinen Abmessung auch unter ungünstigen Bedingungen ohne Schwierigkeiten zu handhaben ist, das aber auch ohne von der Bedienungsperson zu treffende Maßnahmen. Störeinflüsse zuverlässig ausschaltet. Mit einem Spannungs-Fernprüfer der eingangs genannten Art ist diese Aufgabe erfindungsgemäß dadurch gelöst, daß der Griff elektrisch isolierend ausgebildet ist und daß das Prüfgerät mit einer kapazitiv an ein sich in der Nähe befindendes, geerdetes Bauteil eines Leitungsträgers ankoppelbaren Elektrode und/oder einem freiliegenden Erdungskontakt versehen ist.

Der Einsatz der erfindungsgemäßen Spannungsprüfers erfolgt in der Weise, daß der Benutzer sich auf die Traverse direkt über die zu prüfende Leitung begibt und das Gerätegehäuse durch die Traverse hindurch bis zu der am traversenseitigen Ende des Isolators vorgesehenen, aus Erdpotential liegenden Schutzarmatur hindurchführt und dann in einer Lage, in welcher die Antenne auf den zu prüfenden Leiter ausgerichtet ist, den freiliegenden Erdungskontakt oder die Elektrode in Anlage an die Schutzarmatur bringt. Weist das Prüfgerät eine Elektrode auf, so genügt es auch, diese in die Nähe der Schutzarmatur zu bringen.

Die Antenne spricht dann nur auf denjenigen Leiter an, auf den sie ausgerichtet ist. Störeinflüsse durch andere Systeme oder den Masten können sich dabei auf die Anzeige nicht auswirken. Da der Spannungsprüfer nur dann funktioniert, wenn sein freiliegender Erdungskontakt oder seine Elektrode in Anlage an die Schutzarmatur gebracht wird oder die Elektrode sich zumindest in deren Nähe befindet, ist durch konstruktive Maßnahmen sichergestellt, daß der Benutzer für die Messung das Gerät in die richtige Lage bringt. Außerdem wird vorteilhafterweise die Länge des Griffes so gering gewählt, daß das Gerätegehäuse und die Antenne nur bis in Höhe der traversenseitigen Schutzarmatur dem zu prüfenden Leiter genähert werden kann. Für den den Griff bildenden Stab genügt daher eine Länge von weniger als einem Meter. Da die gegebenenfalls erforderliche Erdung des Prüfgerätes über den Erdungskontakt oder die Elektrode erfolgt, kann der den Griff bildende Stab elektrisch isolierend sein, wodurch eine zusätzliche Sicherheit für den Benutzer des Spannungsprüfers erreicht wird. Der Benutzer kann deshalb den erfindungsgemäßen Spannungsprüfer sowohl wegen der geringen Länge des den Griff bildenden Stabes als auch wegen dessen Isolierfähigkeit gefahrlos handhaben.

Der Erdungskontakt kann durch das metallische Gerätegehäuse gebildet sein. Dasselbe gilt für die Elektrode. Man kann aber als Erdungskontakt auch einen Kontaktfinger oder einen Haken vorsehen, welcher vom Gerätegehäuse absteht. Dieses kann dann mit einem elektrisch isolierenden Überzug versehen sein, was auch dann der Fall ist, wenn eine Elektrode vorhanden ist.

Bei einer bevorzugten Ausführungsform ist der den Griff bildende Stab teleskopisch verlängerbar ausgebildet. Der Stab kann dann für die Aufbewahrung sowie für den Transport zur Meßstelle auf seine kleinste Länge verkürzt und nur für die Messung auf den Maximalwert verlängert werden.

Zweckmäßigerweise wird eine die Inbetriebnahme des Prüfgerätes nur nach Erfüllung der für eine ordnungsgemäße Handhabung notwendigen Voraussetzungen zulassende Sicherungseinrichtung vorgesehen. Bei diesen Voraussetzungen kann es sich sowohl um die für eine fehlerfreie Spannungsprüfung wichtige Anordnung des Gerätegehäuses als auch um die aus Sicherheitsgründen empfehlenswerte Einstellung der maximalen Länge des den Griff bildenden Stabes bei einer teleskopisch verlängerbaren Ausbildung dieses Stabes handeln.

Eine vorteilhafte Ausführungsform mit einem den Griff bildenden, teleskopisch verlängerbaren Stab weist deshalb an dem relativ zum Gerätegehäuse bewegbaren Stababschnitt, der relativ zu dem fest mit dem Gerätegehäuse verbundenen Stababschnitt um seine Längsachse drehbar ist, eine Sichtblende auf, die von einer bei minimaler Stablänge die Anzeigeeinrichtung abdeckenden Lage durch eine Rotationsbewegung des sie tragenden Stababschnittes relativ zum Gerät in eine den Blick auf die Anzeigeeinrichtung freigebende Stellung bei maximaler Stablänge schwenkbar ist. Durch eine solche Sichtblende, welche vorzugsweise bei minimaler Stablänge auch den Einschaltknopf des Spannungsprüfers abdeckt, kann in einfacher Weise sichergestellt werden, daß der Benutzer nicht in der Lage ist, die Spannungsprüfung auszuführen, ohne vorher den den Griff bildenden Stab auf seine maximale Länge ausgezogen zu haben.

Zusätzlich oder statt dieser Sichtblende kann die Sicherungseinrichtung einen Schalter aufweisen, der mittels des relativ zu dem fest mit dem Gerätegehäuse verbundenen Stangenabschnitts bewegbaren Stangenabschnitt betätigbar und nur bei maximaler Länge des Stabes geschlossen ist.

Eine Spannungsprüfung kann also erst vorgenommen werden, nachdem der Stab auf seine maximale Länge ausgezogen worden ist. Zusätzlich kann hierbei die Sicherungseinrichtung einen am Gerätegehäuse vorgesehenen, zum Griff hin offenen Haken und eine ständig den Stab zu verkürzen suchende, vorzugsweise im Stab angeordnete Zugfeder aufweisen. Die Bedienungsperson ist dann gezwungen, den Haken in die Schutzarmatur einzuhängen, um den Stab auf seine maximale Länge verlängern und damit das Prüfgerät einschalten zu können, wodurch zwangsläufig das Gerätegehäuse während der Prüfung in der richtigen Lage gehalten wird. Vorteilhafter Weise wird in diesem Falle dann, wenn das Gerät mit einem Erdungskontakt ausgerüstet ist, dieser durch den Haken gebildet.

Im folgenden ist die Erfindung anhand von drei in der Zeichnung dargestellten Ausführungsbeispielen im einzelnen erläutert. Es zeigen :

Figur 1  eine teilweise im Schnitt dargestellte Ansicht des ersten Ausführungsbeispiels bei minimaler Grifflänge,

Figur 2  eine Ansicht des ersten Ausführungsbeispiels im betriebsbereiten Zustand,

Figur 3  eine teilweise im Schnitt dargestellte Ansicht eines zweiten Ausführungsbeispiels,

Figur 4  die Anordnung des ersten und zweiten Ausführungsbeispiels während einer Spannungsprüfung.

Figur 5  eine schematisch und teilweise in Schnitt dargestellte Ansicht des dritten Ausführungsbeispiels bei minimaler Grifflänge,

Figur 6  eine Ansicht des dritten Ausführungsbeispiels im betriebsbereiten Zustand.

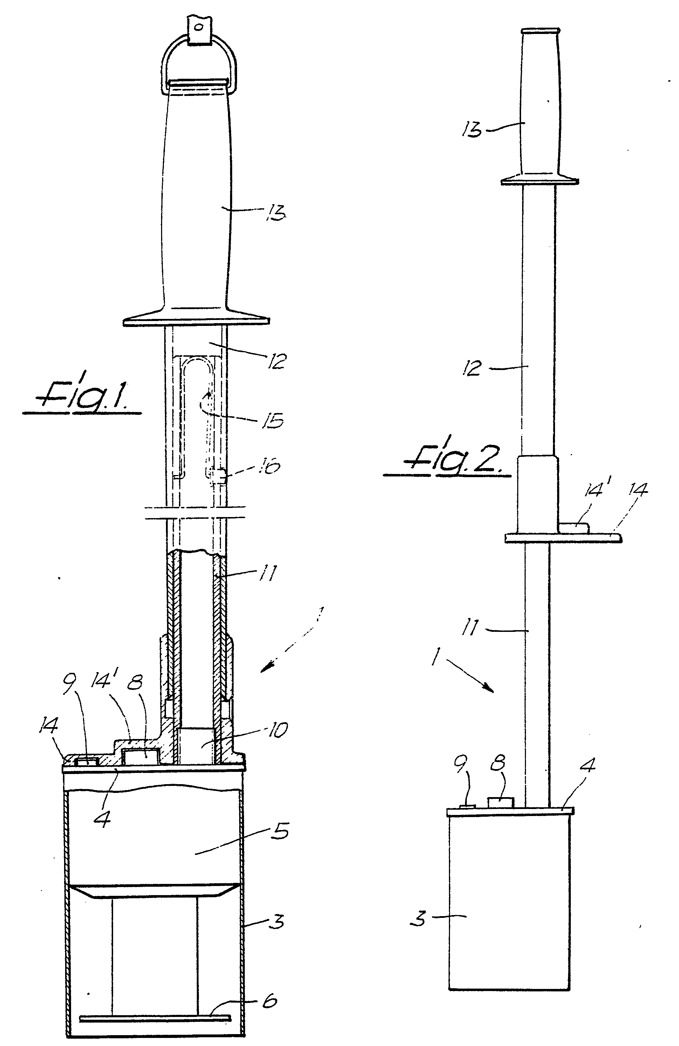

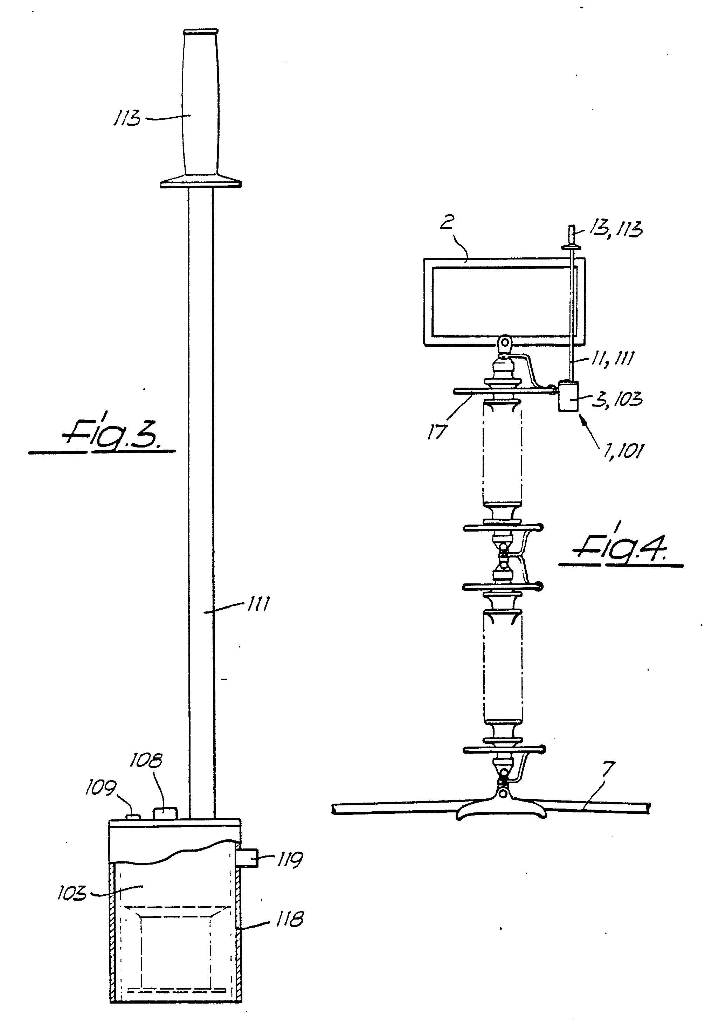

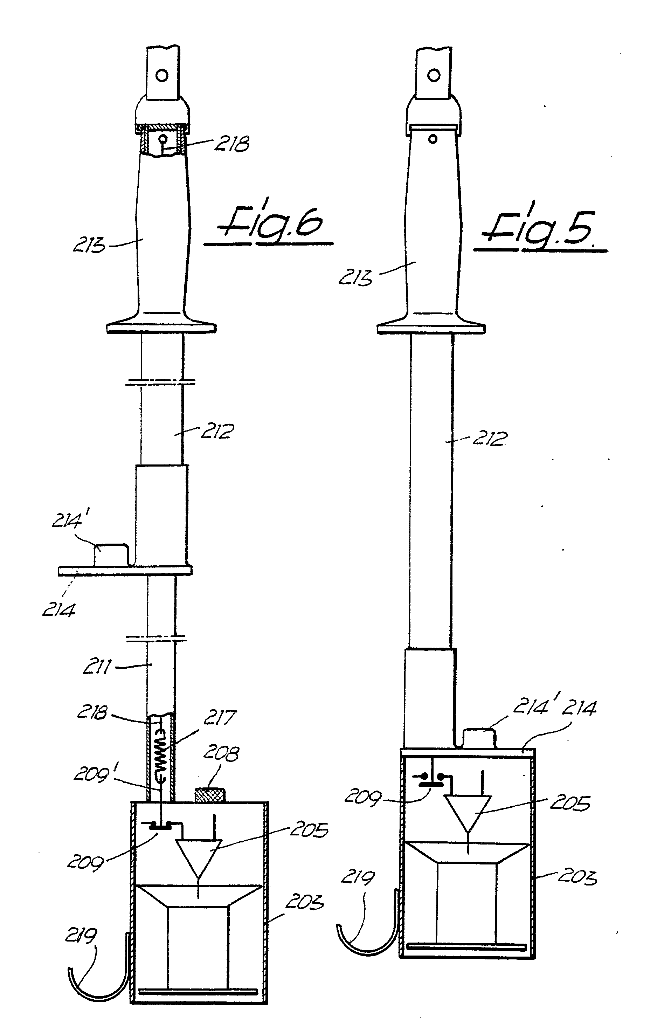

Eine Spannungsprüfer 1 zur Spannungsprüfung an Freileitungen von Hochspannungs-Energieversorgungsnetzen, welche mittels Isolatoren an eine Masttraverse 2 (Fig. 4) angehängt sind, weist ein metallisches, zylindrisches Gerätegehäuse 3 auf, dessen Außenseite nicht isoliert ist. Das an seinem einen Ende durch einen Boden 4 verschlossene Gerätegehäuse enthält ein elektronisches Prüfgerät 5 und nahe seinem dem Boden 4 abgekehrten, offenen Ende eine parallel zum Boden liegende Scheibenantenne 6, die von einem Träger des Prüfgerätes 5 in dieser Lage gehalten wird. Wie Fig. 1 zeigt, weist das eine Abschirmung bildende Gerätegehäuse 3 einen gewissen Überstand über die Scheibenantenne 6 auf.

Der Boden 4 trägt eine Anzeigeeinrichtung 8, welche die Funktionsfähigkeit und den Spannungszustand des zu prüfenden Leiters optisch und/oder akustisch anzeigt. Im Ausführungsbeispiel erfolgt nur eine optische Anzeige mittels zweier Lampen. Außerdem trägt der Boden 4 einen vom Benutzer zu betätigenden Schalter 9. Die Abschaltung erfolgt selbsttätig.

Außermittig steht, wie Fig. 1 zeigt, vom Boden 4 ein parallel zur Längsachse des Gerätegehäuses 3 liegender Verbindungszapfen 10 ab, mit dem das eine Ende eines ersten Isolierrohres 11 fest verbunden ist. Das erste Isolierrohr 11 bildet zusammen mit einem zweiten Isolierrohr 12, das an seinem dem Gerätegehäuse 3 abgekehrten Ende einen Handgriff 13 trägt, einen teleskopisch verlängerbaren Stab. Wenn dieser Stab auf seine maximale Länge ausgezogen ist, beträgt die Länge des Spannungsprüfers, gemessen vom freien Ende des Gerätegehäuses 3 bis zum freien Ende des Handgriffes 13 etwa 1 m. Durch die Verkürzung des Stabes auf seine minimale Länge läßt sich dieser Wert auf etwa 60 cm verringern.

Das gegen das Gerätegehäuse 3 weisende Ende des über das erste Isolierrohr 11 übergeschobenen zweiten Isolierrohres 12 trägt, wie Fig. 2 zeigt, eine aus Kunststoff bestehende Abdeckscheibe 14, deren Durchmesser etwa gleich dem Durchmesser des Bodens 4 ist. Die parallel zum Boden 4 und damit in einer Radialebene der beiden Isolierrohre 11 und 12 liegende Abdeckscheide wird an einer Stelle vom ersten Isolierrohr 11 durchdrungen, welche im selben Maße gegenüber dem Zentrum radial versetzt ist wie der Verbindungszapfen 10 gegenüber dem Zentrum des Bodens 4. Die Abdeckscheibe 14 kann deshalb, wie Fig. 1 zeigt, in eine Lage gebracht werden, in welche sie den Boden 4 und die Anzeigeeinrichtung 8 sowie den Schalter 9 vollständig abdeckt. Damit sie dabei am Boden 4 anliegen kann, ist sie für die Aufnahme der Anzeigeeinrichtung 8 mit einer Kappe 14' und für die Aufnahme des Schalters 9 mit einer Vertiefung versehen. Um die Abdeckscheibe 14 in Anlage an den Boden 4 bringen zu können, muß der aus den beiden Isolierrohren 11 und 12 bestehende Stab auf seine minimale Länge verkürzt werden.

In derjenigen Stellung, in welcher die Abdeckscheibe 14 den Boden 4 vollständig abdeckt und an ihm anliegt, sowie in derjenigen Stellung, in welcher der aus den beiden Isolierrohren 11 und 12 bestehende Stab seine maximale Länge hat und die Abdeckscheibe um 180° verschwenkt ist, damit sie den Zugang zum Schalter 9 und den Blick auf die Anzeigeeinrichtung 8 freigibt, wie dies Fig. 2 zeigt, sind die beiden Isolierrohre 11 und 12 mittels einer Arretiereinrichtung miteinander verriegelbar. Diese Arretiereinrichtung besteht im Ausführungsbeispiel aus einer in dem dem Boden 4 abgekehrten Endabschnitt des ersten Isolierrohres 11 angeordneten Haarnadelfeder 15, deren eines nach außen abgewinkeltes Schenkelende einen Verriegelungsstift 16 trägt. Dieser in einer radialen Bohrung des ersten Isolierrohres 11 geführte Verriegelungsstift kann in Bohrungen od. dgl. des zweiten Isolierrohres 12 einrasten.

Das metallische, außen blanke Gerätegehäuse 3 bildet einen Erdungskontakt des Prüfgerätes, der mit der am traversenseitigen Ende der Isolatoren vorgesehenen Schutzarmatur 17 (Fig. 4) in Berührung gebracht werden muß, um den Spannungsprüfer funktionsfähig zu machen.

Für eine Spannungsprüfung begibt sich die Bedienungsperson auf die Masttraverse 2 an eine unmittelbar über dem zu prüfenden Leiter 7 liegende Stelle (Fig. 4). Sie verlängert dann den aus den beiden Isolierrohren 11 und 12 bestehenden Stab auf seine maximale Länge und dreht dabei das zweite Isolierrohr 12 relativ zum ersten Isolierrohr 11 um 180°, damit die Abdeckscheibe 14 von der in Fig. 1 dargestellten Abdeckstellung in die in Fig. 2 dargestellte Freigabestellung kommt. Nun wird das Prüfgerät 5 durch eine Betätigung des Schalters 9 eingeschaltet und durch die Traverse hindurch bis zur Anlage des Gerätegehäuses 3 an der Schutzarmatur 17 gebracht. Die Scheibenantenne 6 wird dann noch, soweit erforderlich, auf den Leiter 7 ausgerichtet. Wegen der relativ geringen Länge des aus den beiden Isolierrohren 11 und 12 und dem Handgriff 13 bestehenden Stabes ist der Benutzer gezwungen, den Spannungsprüfer während der Handhabung für den Prüfvorgang am isolierenden Handgriff 13 zu halten, wodurch eine zusätzliche Sicherheit erreicht wird.

Nach Beendigung der Messung wird der isolierende Stab zweckmäßigerweise für den Rücktransport des Spannungsprüfers wieder auf seine minimale Länge verkürzt.

Das in Fig. 3 dargestellte, zweite Ausführungsbeispiel unterscheidet sich von dem ersten Ausführungsbeispiel nur hinsichtlich der Ausbildung des Erdungskontaktes und des den Griff bildenden Stabes. Daher werden im folgenden nur diese Unterschiede erläutert. Im übrigen wird auf die Ausführungen zum ersten Ausführungsbeispiel Bezug genommen.

Wie Fig. 3 zeigt, trägt das metallische Gerätegehäuse 103 auf seiner Außenseite einen elektrisch isolierenden Mantel 118. Es kann deshalb nicht als Erdungskontakt dienen. Daher ist der Erdungskontakt als ein den Mantel 118 durchdringender, radial vom Gerätegehäuse 103 abstehender Kontaktstift 119 ausgebildet, der für die Messung in Anlage an die oberste Schutzarmatur 17 des Isolators gebracht werden muß.

Ein weiterer Unterschied besteht darin, daß der das Gerätegehäuse 103 tragende Stab ein längenunveränderbares Isolierrohr 111 mit Griff 113 ist, dessen Länge entsprechend der maximalen Länge des aus den Isolierrohren 11 und 12 des ersten Ausführungsbeispiels gebildeten Stabes gewählt ist.

Das in den Figuren 5 und 6 dargestellte Ausführungsbeispiel ist weitgehend wie dasjenige gemäß den Figuren 1 und 2 ausgebildet. Daher sind sich entsprechende Teile mit um 200 größeren Bezugszahlen gekennzeichnet und im folgenden nur die Unterschiede erläutert. Soweit dieses dritte Ausführungsbeispiel nicht im einzelnen beschrieben ist, ist es also wie dasjenige gemäß den Figuren 1 und 2 ausgebildet.

Der Schalter 209, der geschlossen werden muß, um das elektronische Prüfgerät funktionsfähig zu machen, wird nicht wie bei dem Ausführungsbeispiel gemäß den Figuren 1 und 2 mittels einer Drucktaste betätigt. Vielmehr ist, wie Fig. 6 zeigt, sein Betätigungsglied 209', das in das fest mit dem Gerätegehäuse 203 verbundene erste Isolierrohr 211 hineinragt, über eine Zugfeder 217, die ebenfalls im ersten Isolierrohr 211 angeordnet ist, mit dem einen Ende eines Zugseiles 218 verbunden, dessen anderes Ende im Inneren des Handgriffes 213 festgelegt ist, der an dem dem Gerätegehäuse 203 abgekehrten Ende des zweiten Isolierrohres 212 vorgesehen ist. Das zweite Isolierrohr 212 übergreift das erste Isolierrohr 211 und bildet zusammen mit diesem einen teleskopisch verlängerbaren, elektrisch isolierenden Stab. Die Länge des Zugseils 218 ist so gewählt, daß es die Zugfeder 217 zu spannen beginnt, kurz ehe die maximale Länge des Stabes erreicht ist. Der Schalter 209, den eine nicht dargestellte Rückstellfeder in der geöffneten Stellung zu halten sucht, ist deshalb nur dann und so lange geschlossen, als der den Griff bildende Stab auf seine maximale Länge ausgezogen ist. Nur dann verbindet nämlich der Schalter 209 das Prüfgerät 205 mit der nicht dargestellten, die Energiequelle bildenden Batterie.

Die Sicherungseinrichtung, welche eine Inbetriebnahme des Spannungsprüfers nur zulässt, wenn der durch die beiden Isolierrohre 211 und 212 gebildete Stab auf seine maximale Länge ausgezogen ist, weist außer dem Schalter 209 noch die Abdeckscheibe 214 auf, welche an dem dem Gerätegehäuse 203 zugekehrten Ende des zweiten Isolierrohres 212 vorgesehen ist und wie bei dem Ausführungsbeispiel gemäß den Figuren 1 und 2 den Blick des Benutzers auf die Anzeigeeinrichtung 208 nur dann freigibt, wenn der Stab auf seine maximale Länge ausgezogen und das zweite Isolierrohr 212 um 180° relativ zum ersten Isolierrohr 211 geschwenkt worden ist. In der in Fig. 5 dargestellten Transportstellung, in welcher der Stab auf seine minimale Länge verkürzt ist, deckt die Abdeckscheibe 214 die dem Handgriff 213 zugekehrte Seite des Gerätegehäuses 203 vollständig ab. Eine Kappe 214' überdeckt dabei die Anzeigeeinrichtung 8.

An dem metallischen, zylindrischen Gerätegehäuse 203 ist seitlich ein metallischer, zum Handgriff 213 hin offener Haken 219 befestigt, welcher den Erdungskontakt bildet. Der Hakten 219 stellt also die als Voraussetzung für eine Inbetriebnahme des Spannungsprüfers notwendige Erdung her, wenn er in den in Fig. 4 dargestellten, geerdeten Schutzring eingehängt wird. Gleichzeitig hält er das Gerätegehäuse 203 in der für die Messung optimalen Position.

Selbstverständlich könnte der Haken 219 auch nur der Positionierung des Gerätegehäuses bei der Messung dienen und das Prüfgerät 205 über eine Elektrode an den vom Haken 219 erfassten, geerdeten Schutzring angekoppelt sein. Diese Elektrode könnte ebenfalls durch den Mantel des Gerätegehäuses 203 gebildet werden. Dieser Mantel wäre dann aber mit einer Isolierschicht überzogen, und auch der Haken 219 wäre gegenüber dieser Elektrode isoliert.

Ferner wäre es möglich, zusätzlich zu der Zugfeder 217 in den beiden Isolierrohren 211 und 212 eine zweite Zugfeder anzuordnen, welche ständig den durch die beiden Isolierrohre gebildeten Stab auf seine minimale Länge zu verkürzen suchen würde. Die Bedienungsperson müßte dann während der Messung ständig auf den Griff 213 eine Zugkraft ausüben, wodurch sichergestellt wäre, daß der Haken 219 in Anlage am Schutzring gehalten würde.

**Ansprüche**

1. Spannungs-Fernprüfer für Prüfungen in Hochspannungs-Energieversorgungsnetzen, insbesondere für die Prüfung von Hochspannungsfreileitungen, mit einem als Stab ausgebildeten Griff (11, 12, 13 ; 111, 113 ; 211, 212, 213), der ein Gerätegehäuse (3 ; 103 ; 203) trägt, in dem sich ein Prüfgerät (5 ; 205) befindet, das auf der dem Griff abgekehrten Seite eine Antenne (6) und auf der dem Griff zugekehrten Seite eine Anzeigeeinrichtung (8 ; 108 ; 208) aufweist sowie während der Prüfung mit Erdpotential verbunden ist, dadurch gekennzeichnet, daß der Griff elektrisch isolierend ausgebildet ist und daß das Prüfgerät (5 ; 205) mit einer kapazitiv an ein sich in der Nähe befindendes, geerdetes Bauteil eines Leitungsträgers ankoppelbaren Elektrode (203) und/oder mit einem an das geerdete Bauteil anlegbaren, freiliegenden Erdungskontakt (3 ; 119 ; 219) versehen ist.

2. Spannungs-Fernprüfer nach Anspruch 1, dadurch gekennzeichnet, daß die Elektrode durch das metallische Gerätegehäuse gebildet ist.

3. Spannungs-Fernprüfer nach Anspruch 1, dadurch gekennzeichnet, daß der Erdungskontakt durch das metallische Gehäuse (3) gebildet ist.

4. Spannungs-Fernprüfer nach einem der Ansprüche 1 bis 3, gekennzeichnet durch einen seitlich am Gerätegehäuse (203) angeordneten, zum Griff (211, 212, 213) hin offenen Haken (219).

5. Spannungs-Fernprüfer nach einem der Ansprüche 1 bis 4, dadurch gekennzeichnet, daß der Erdungskontakt durch einen von dem vorzugsweise mit einem elektrisch isolierenden Überzug (118) versehenen Gerätegehäuse (103 ; 203) abstehenden Kontaktfinger (119 ; 219) gebildet ist.

6. Spannungs-Fernprüfer nach Anspruch 4 oder 5, dadurch gekennzeichnet, daß der Haken (219) den Kontaktfinger bildet.

7. Spannungs-Fernprüfer nach einem der Ansprüche 1 bis 6, dadurch gekennzeichnet, daß der den Griff bildende Stab (11, 12, 13 ; 211, 212, 213) teleskopisch verlängerbar ausgebildet ist.

8. Spannungs-Fernprüfer nach Anspruch 7, dadurch gekennzeichnet, daß der Griff (11, 12, 13 ; 211, 212, 213) eine die relativ zueinander verschiebbaren Stabteile (11, 12 ; 211, 212) in der Stellung maximalen Auszugs haltende Arretiervorrichtung (15, 16) aufweist.

9. Spannungs-Fernprüfer nach einem der Ansprüche 1 bis 8, gekennzeichnet durch eine seine Inbetriebnahme nur nach Erfüllung der für eine ordnungsgemäße Handhabung notwenigen Voraussetzungen zulassende Sicherungseinrichtung (14, 209, 217, 218, 214).

10. Spannungs-Fernprüfer nach Anspruch 9, dadurch gekennzeichnet, daß der teleskopisch verlängerbare Stab (11, 12, 13 ; 211, 212, 213) an dem relativ zum Gerätegehäuse (3 ; 203) bewegbaren Stababschnitt (12 ; 212), der relativ zu dem fest mit dem Gerätegehäuse (3 ; 203) verbundenen Stababschnitt (11 ; 211) um seine Längsachse drehbar ist, eine Sichtblende (14, 14' ; 214, 214') aufweist, die von einer bei minimaler Stablänge die Anzeigeeinrichtung 8 ; 208) abdeckenden Lage durch eine Rotationsbewegung des sie tragenden Stababschnitts (12 ; 212) relativ zum Gerätegehäuse (3 ; 203) in eine den Blick auf die Anzeigeeinrichtung (8 ; 208) freigebende Stellung bei maximaler Stablänge schwenkbar ist.

11. Spannungs-Fernprüfer nach Anspruch 10, dadurch gekennzeichnet, daß die Sichtblende eine in einer Radialebene des Stabes (11, 12, 13 ; 211, 212, 213) liegende Platte (14 ; 214) ist.

12. Spannungs-Fernprüfer nach einem der Ansprüche 9 bis 11, dadurch gekennzeichnet, daß die Sicherungseinrichtung einen für eine Inbetriebnahme zu schließenden Schalter (209) aufweist, der mittels des relativ zu dem fest mit dem Gerätegehäuse (203) verbundenen Stababschnitt (211) bewegbaren Stababschnitts (212) betätigbar und nur bei maximaler Länge des Stabes geschlossen ist.

13. Spannungs-Fernprüfer nach Anspruch 12, dadurch gekennzeichnet, daß die Sicherungseinrichtung einem am Gerätegehäuse (203) vorgesehenen, zum Griff (211, 212, 213) hin offenen Haken (219) und eine ständig den Stab zu verkürzen suchende, vorzugsweise im Stab angeordnete Zugfeder aufweist.

14. Spannungs-Fernprüfer nach einem der Ansprüche 1 bis 13, für eine Spannungsprüfung einer Hochspannungsfreileitung (7), die an eine Traverse (2) eines Mastes mittels eines an seinem traversenseitigen Ende eine geerdete Schutzarmatur (17) aufweisenden Isolators angehängt ist, dadurch gekennzeichnet, daß die Elektrode (203) und der freiliegende Erdungskontakt (3 ; 119 ; 219) für eine kapazitive bzw. galvanische Ankopplung an die Schutzarmatur (17) ausgebildet sind.

## Claims

1. Long distance voltage tester for carrying out tests in high voltage energy supply grids, in particular for testing high voltage overhead lines, having a handle (11, 12, 13 ; 111, 113 ; 211, 212, 213) in the form of a rod carrying an instrument housing (3 ; 103 ; 203) containing a testing instrument (5 ; 105) which has an aerial (6) on the side remote from the handle and an indicator (8 ; 108 ; 208) on the side facing the handle and is connected to earth potential during testing, characterised in that the handle is designed to be electrically insulating and in that the testing instrument (5 ; 205) is provided with an electrode (203) which can be capacitively connected to an earthed part (17) of a conductor carrier (2, 17) situated nearby and/or it is provided with a freely exposed earthing contact (3 ; 119 ; 219) which can be placed against the earthed part (17).

2. Long distance voltage tester according to Claim 1, characterised in that the electrode is formed by the metallic instrument housing.

3. Long distance voltage tester according to Claim 1, characterised in that the earthing contact is formed by the metallic housing (3).

4. Long distance voltage tester according to one of the Claims 1 to 3, characterised by a hook (219) which is arranged at the side of the instrument housing (203) and is open to the handle (211, 212, 213).

5. Long distance voltage tester according to one of the Claims 1 to 4, characterised in that the earthing contact is formed by a contact finger (119 ; 219) projecting from the instrument housing (103 ; 203) which is preferably provided with an electrically insulating cover (118).

6. Long distance voltage tester according to Claim 4 or 5, characterised in that the contact finger is formed by the hook (219).

7. Long distance voltage tester according to one of the Claims 1 to 6, characterised in that the rod (11, 12, 13 ; 211, 212, 213) forming the handle is telescopically extensible.

8. Long distance voltage tester according to Claim 7, characterised in that the handle (11, 12, 13 ; 211, 212, 213) has a stop device (15, 16) which maintains the rod parts (11, 12 ; 211, 212) which are relatively displaceable to one another in their position of maximum extension.

9. Long distance voltage tester according to one of the Claims 1 to 8, characterised by a safety device (14, 209, 117, 218, 214) which ensures that the voltage tester can only be put into operation when the preconditions necessary for its correct handling have been fulfilled.

10. Long distance voltage tester according to Claim 9, characterised in that the telescopically extensible rod (11, 12, 13 ; 211, 212, 213) has a viewing shutter (14, 14' ; 214, 214') on that section (12 ; 212) of the rod which is displaceable relative to the instrument housing (3 ; 203) and which is rotatable about its longitudinal axis relative to that section (11 ; 211) of the rod which is fixed to the instrument housing (3 ; 203), which shutter can be swung from the position in which it covers the indicator (8 ; 208) when the rod is at its minimum length into a position in which it exposes the indicator (8 ; 208) to view when the rod is at its maximum length by a movement of rotation of the rod section (12 ; 212) carrying it relative to the instrument housing (3 ; 203).

11. Long distance voltage tester according to Claim 10, characterised in that the viewing shutter is a plate (14 ; 214) lying in a radial plane of the rod (11, 12, 13 ; 211, 212, 213).

12. Long distance voltage tester according to one of the Claims 9 to 11, characterised in that the safety device comprises a switch (209) which is required to be closed for operating the tester, which switch (209) can be actuated by means of that rod section (212) which is displaceable relative to the rod section (211) which is fixed to the instrument housing (203), and the switch (209) is only closed when the rod is extended to its maximum length.

13. Long distance voltage tester according to Claim 12, characterised in that the safety device comprises a hook (219) which is provided on the instrument housing (203) and open to the handle (211, 212, 213) and a tension spring which constantly tends to shorten the rod and is preferably arranged in the rod.

14. Long distance voltage tester according to one of the Claims 1 to 13, for testing the voltage of a high voltage overhead line (7) which is suspended to a traverse (2) of a mast by means of an insulator which has an earthed protective armature (17) at its end close to the traverse, characterised in that the electrode (203) and the exposed earthing contact (3 ; 119 ; 219) are designed to be capacitively or galvanically connected to the protective armature (17).

## Revendications

1. Contrôleur de tension à distance pour des contrôles dans des réseaux d'alimentation en énergie à haute tension, notamment pour le contrôle de lignes aériennes à haute tension, comportant une poignée (11, 12, 13 ; 111, 113 ; 211, 212, 213) réalisée sous la forme d'un barreau et qui porte le boîtier de l'appareil (3 ; 103 ; 203) dans lequel est situé un appareil de contrôle (5 ; 205) qui porte une antenne (6) sur le côté tourné à l'opposé de la poignée et un dispositif indicateur (8 ; 108 ; 208) sur le côté tourné vers la poignée et est relié pendant le contrôle au potentiel de la terre, caractérisé en ce que la poignée est réalisée électriquement isolante et que l'appareil (5 ; 205) est équipé d'une électrode (203) pouvant être accouplée capacitivement à un composant (17), situé à proximité et mis à la terre, d'un porte-conducteur (2, 17), et/ou d'un contact de mise à la terre (3 ; 119 ; 219) dégagé pouvant être appliqué contre le composant (17) mis à la terre.

2. Contrôleur de tension à distance selon la revendication 1, caractérisé en ce que l'électrode est formée par le boîtier métallique de l'appareil.

3. Contrôleur de tension à distance selon la revendication 1, caractérisé en ce que le contact de mise à la terre est formé par le boîtier métallique (3).

4. Contrôleur de tension à distance selon l'une des revendications 1 à 3, caractérisé par un crochet (219) monté latéralement sur le boîtier (203) de l'appareil est ouvert en direction de la poignée (211, 212, 213).

5. Contrôleur de tension à distance selon l'une des revendications 1 à 4, caractérisé en ce que le contact de mise à la terre est formé par un doigt de contact (119 ; 219) faisant saillie par rapport au boîtier (103 ; 203) de l'appareil équipé de préférence d'un revêtement électriquement isolant (118).

6. Contrôleur de tension à distance selon la revendication 4 ou 5, caractérisé en ce que le crochet (219) forme le doigt de contact.

7. Contrôleur de tension à distance selon l'une des revendications 1 à 6, caractérisé en ce que le barreau (11, 12, 13 ; 211, 212, 213) constituant la poignée est réalisé de manière à être déployable de façon télescopique.

8. Contrôleur de tension à distance selon la revendication 7, caractérisé en ce que la poignée (11, 12, 13 ; 211, 212, 213) possède un dispositif de blocage (15, 16) maintenant les parties (11, 12 ; 211, 212) du barreau, déplaçables l'une par rapport à l'autre, dans la position de déploiement maximum.

9. Contrôleur de tension à distance selon l'une des revendications 1 à 8, caractérisé par un dispositif de protection (14, 209, 217, 218, 214) autorisant sa mise en service uniquement après que des conditions préalables nécessaires pour une manipulation correcte sont satisfaites.

10. Contrôleur de tension à distance selon la revendication 9, caractérisé en ce que le barreau (11, 12, 13 ; 211, 212, 213) déployable de façon télescopique comporte, au niveau de sa section (12 ; 212), déplaçable par rapport au boîtier (3 ; 203) de l'appareil et qui peut être entraînée en rotation autour de son axe longitudinal par rapport à la section du barreau (11 ; 211) reliée rigidement au boîtier (3 ; 203) de l'appareil, un obturateur (14, 14' ; 214, 214'), qui peut pivoter depuis une position recouvrant le dispositif indicateur (8 ; 208), lorsque le barreau possède sa longueur minimale, par un mouvement de rotation de la section de barreau (12 ; 212), le portant, par rapport au boîtier (3 ; 203) de l'appareil, dans une position libérant la vue sur le dispositif indicateur (8 ; 208), lorsque la longueur du barreau est maximum.

11. Contrôleur de tension à distance selon la revendication 10, caractérisé en ce que l'obturateur est une plaque (14 ; 214) située dans un plan radial du barreau (11, 12, 13 ; 211, 212, 213).

12. Contrôleur de tension à distance selon l'une des revendications 9 à 11, caractérisé en ce que le dispositif de sécurité possède un commutateur (209) devant être fermé pour une mise en service et qui peut être actionné au moyen de la section de barreau (212) déplaçable par rapport à la section de barreau (211) reliée rigidement au boîtier (203) de l'appareil, et n'est fermé que lorsque le barreau possède sa longueur maximum.

13. Contrôleur de tension à distance selon la revendication 12, caractérisé en ce que le dispositif de sécurité comporte un crochet (219) prévu sur le boîtier (203) de l'appareil et ouvert en direction de la poignée (211, 212, 213), et un ressort de traction tendant à raccourcir en permanence le barreau et monté de préférence dans ce dernier.

14. Contrôleur de tension à distance selon l'une des revendications 1 à 13, pour un contrôle de tension d'une ligne aérienne à haute tension (7), qui est suspendue à une traverse (2) d'un pylône au moyen d'un isolateur comportant sur son extrémité situé du côté de la traverse, un dispositif de protection (17) mis à la terre, caractérisé en ce que l'électrode (203) et le contact dégagé de mise à la terre (3 ; 119 ; 219) sont conçus pour un couplage capacitif ou galvanique au dispositif de protection (17).

_Fig.1._

_Fig.2._

_Fig.3._

_Fig.4._

*Fig.6*     *Fig.5.*